Europäisches Patentamt

European Patent Office

Office européen des brevets

(19)

(11) **EP 0 641 012 B1**

(12) **EUROPÄISCHE PATENTSCHRIFT**

(45) Veröffentlichungstag und Bekanntmachung des Hinweises auf die Patenterteilung:
**23.06.1999 Patentblatt 1999/25**

(51) Int Cl.⁶: **H01J 37/26**

(21) Anmeldenummer: **94108174.7**

(22) Anmeldetag: **27.05.1994**

(54) **Elektronenoptisches Abbildungssystem mit regelbaren Elementen**

Electron-optical imaging system with controllable elements

Système d'imagerie par optique électronique avec éléments réglables

(84) Benannte Vertragsstaaten:
**DE GB NL**

(30) Priorität: **26.08.1993 DE 4328649**

(43) Veröffentlichungstag der Anmeldung:
**01.03.1995 Patentblatt 1995/09**

(73) Patentinhaber:
• **Carl Zeiss**
  **D-89520 Heidenheim (Brenz) (DE)**
  Benannte Vertragsstaaten:
  **DE NL**
• **CARL ZEISS-STIFTUNG HANDELND ALS CARL ZEISS**
  **D-89518 Heidenheim (Brenz) (DE)**
  Benannte Vertragsstaaten:
  **GB**

(72) Erfinder:
• **Weimer, Eugen, Dr.**
  **D-73457 Essingen (DE)**
• **Benner, Gerd, Dr.**
  **D-73434 Aalen (DE)**
• **Ross-Messemer, Dr.**
  **D-73434 Aalen (DE)**
• **Frey, Josef**
  **D-73560 Böbingen (DE)**

(56) Entgegenhaltungen:
**EP-A- 0 488 214       GB-A- 2 215 947**

**Beschreibung**

In der Elektronenoptik werden zur Variation der Abbildungsverhältnisse in der Regel Gruppen aus mehreren den Elektronenstrahl beeinflussenden regelbaren Elementen verwendet. So ist es beispielsweise bekannt, in Elektronenmikroskopen beleuchtungsseitig ein zwei- oder dreilinsiges Abbildungssystem (Kondensorsystem) zu verwenden, damit bei festen Lagen von Elektronenquelle und Objektebene der ausgeleuchtete Objektbereich variabel ist. Ebenso ist es bekannt, daß mit Hilfe eines dreilinsigen abbildungsseitigen Abbildungssystems bei fester Objektebene und Projektionsebene der Abbildungsmaßstab variabel ist, ohne daß bei einer Vergrößerungsvariation eine Bilddrehung auftritt.

Die Abhängigkeit der Abbildungseigenschaften von der angelegten Erregungsspannung lassen sich für einzelne elektronenoptische Abbildungselemente sehr exakt berechnen. Bei der Kombination von mehreren Abbildungselementen bedingen jedoch mechanische Toleranzen und - bei magnetischen Elementen - Remanenzen im Eisenkreis eine zu große Abweichung der tatsächlichen Abbildungseigenschaften, insbesondere bezüglich Scharfstellung, Fokuserhaltung oder Bilddrehung, von den theoretisch berechneten. Bisher auf dem Markt erhältliche Elektronenmikroskope werden daher bei der ersten Inbetriebnahme experimentell abgeglichen, d.h. die zu unterschiedlichen Betriebsbedingungen zugehörigen Erregungen der Abbildungselemente werden durch manuelle Justierung ermittelt und anschließend abgespeichert. Beim späteren Betrieb des Elektronenmikroskops werden dann die zur gewählten Betriebsbedingung zugehörigen Erregungswerte aus dem Speicher ausgelesen und an die Strom- oder Spannungsquellen der Abbildungselemente angelegt. Der hohe Justieraufwand limitiert dabei die Anzahl der wählbaren Betriebsbedingungen. Der Betrieb des Elektronenmikroskopes ist dabei auf die experimentell abgeglichenen diskreten Betriebsbedingungen beschränkt.

In der US-A 4,871,912 ist ein Elektronenmikroskop beschrieben, bei dem auch Betriebsbedingungen einstellbar sein sollen, die nicht zuvor abgeglichen wurden. Dazu ist zusätzlich zu dem üblicherweise im Bedienpult des Elektronenmikroskopes vorhandenen internen Rechner ein externer Rechner vorgesehen. Wird über die Tastatur des externen Rechners beispielsweise ein Vergrößerungswert eingegeben, der zwischen zwei abgeglichenen Vergrößerungsstufen liegt, so werden die zu den beiden benachbarten abgeglichenen Vergrößerungsstufen zugehörigen Parameterwerte des Abbildungssystems in den externen Rechner eingelesen, durch lineare Interpolation zwischen den abgeglichenen Parametern zur eingegebenen Vergrößerung näherungsweise zugehörige Parameter ermittelt und anschließend das Elektronenmikroskop entsprechend dieser Parameter angesteuert.

Da jedoch bei magnetischen Linsen die Abhängigkeit der Brennweite vom Linsenstrom nicht-linear und aufgrund von Remanenzen und Fertigungstoleranzen in der Regel für jede Linse unterschiedlich ist, ist durch die lineare Interpolation eine hinreichend genaue Einstellung der Abbildungsbedingungen bei den Zwischenwerten nicht gewährleistet. Außerdem ist die Eingabe der Zwischenwerte über den externen Rechner sehr zeitaufwendig und unpraktisch; sie erlaubt es beispielsweise nicht, die Vergrößerung kontinuierlich oder in vom Benutzer vorwählbaren feinen Stufen zu variieren und gleichzeitig das Objektbild in der Projektionsebene zu beobachten. Letzteres ist jedoch erforderlich, wenn für ein interessierendes Objektdetail die optimale Vergrößerung eingestellt werden soll.

Eine Interpolation zwischen abgeglichenen Parameterwerten ist auch in der US-A 4,851,674 im Zusammenhang mit einer Astigmatismus- oder Ablenkkorrektur in einem Elektronenmikroskop angesprochen. Hier sind jedoch keine näheren Angaben hinsichtlich der Interpolation enthalten.

Die vorliegende Erfindung soll ein elektronenoptisches Abbildungssystem schaffen, das beim Einsatz in einem Elektronenmikroskop eine komfortablere Bedienung ermöglicht. Insbesondere sollen auch Betriebsbedingungen einstellbar sein, bei denen das Abbildungssystem nicht experimentell abgeglichen ist.

Das erfindungsgemäße elektronenoptische Abbildungssystem umfaßt mehrere regelbare, einen Elektronenstrahl beeinflussende Elemente mit zugehörigen Strom- oder Spannungsquellen, einen Speicher und einen Rechner. In dem Speicher sind Werte abgelegt, die aus experimentell abgeglichenen Parameterwerten des Abbildungssystems bei einer diskreten Folge unterschiedlicher, experimentell abgeglichener Betriebsbedingungen ermittelt sind. Eine Schrittweite $\delta$ ist für eine Änderung der Betriebsbedingungen von der Lage der abgeglichenen Betriebsbedingungen unabhängig vorwählbar. Bei Betätigung eines Bedienelementes erfolgt, ausgehend von der aktuel eingestellten Betriebsbedingung, eine Änderung der Betriebsbdingung entsprechend der vorgewählten Schrittweite $\delta$ in eine neue aktuelle Betriebsbedingung.

Das erfindungsgemäße Abbildungssystem ermöglicht es, Betriebsbedingungen einzustellen, bei denen kein experimenteller Abgleich stattgefunden hat. Im Gegensatz zum Stand der Technik müssen jedoch nicht konkrete Betriebsbedingungen über eine Rechnertastatur eingegeben werden. Die Änderung der Betriebsbedingungen ist vielmehr schrittweise möglich, wobei die Schrittweite beliebig einstellbar ist. Insbesondere bei Verwendung eines derartigen Abbildungssystemes in einem Elektronenmikroskop ergibt sich dabei der Vorteil, daß die Betriebsbedingungen, z.B. die Vergrößerung, sukzessiv vom Operateur bei gleichzeitiger Beobachtung des Objektbildes variiert werden kann. Dabei ist es insbesondere vorteilhaft, wenn die Änderung der Betriebsbedingungen direkt am Bedienpult des Elektronenmikroskopes, beispielsweise durch Auf- und Abtaster, möglich ist. Auch die Auswahl der Schrittweite sollte direkt an diesem Bedienpult möglich sein.

Die zu den aktuell eingestellten Betriebsbedingungen zugehörigen Regelsignale der Strom- oder Spannungsquellen werden aus den abgespeicherten Werten im Rechner berechnet. In einem vorteilhaften Ausführungsbeispiel sind die abgespeicherten Werte Koeffizienten von Näherungsfunktionen, wobei die Regelsignale für die Strom- oder Spannungsquellen anhand dieser Koeffizienten und der zugehörigen Näherungsfunktionen im Rechner berechnet werden. Je nachdem wie gut die Näherungsfunktion den tatsächlichen Verlauf der Strom- oder Spannungskennlinie des zu variierenden Parameters approximiert, um so besser stimmen die berechneten Regelsignale mit den zu den gleichen Betriebsbedingungen zugehörigen idealen Regelsignalen, die bei einem experimentellen Abgleich unter diesen Bedingungen gewonnen würden, überein. Geeignete Näherungsfunktionen brauchen dabei nur einmal beim Abgleich des Abbildungssystems, also bei dessen ersten Inbetriebnahme, ermittelt zu werden. Die Näherungsfunktionen selbst sind dann später anhand weniger abgespeicherter Koeffizienten mit geringem Rechenaufwand rekonstruierbar.

Die Näherungsfunktionen sollten dabei jeweils stückweise stetig sein, wobei zwei aneinander anschließende Näherungsfunktionen jeweils überlappende Stetigkeitsintervalle aufweisen sollten. Durch die stetigen Näherungsfunktionen und den Überlapp der Stetigkeitsintervalle lassen sich über einen großen Bereich unterschiedlicher Betriebsbedingungen, z.B. unterschiedlicher Vergrößerungen, eindeutige Regelsignale berechnen.

Als besonders vorteilhaft haben sich Polynome zweiten Grades für die Näherungsfunktionen erwiesen. Zum einen approximieren diese die Vergrößerungs - Stromkennlinie der in Elektronenmikroskopen üblicherweise eingesetzten Magnetlinsen sdückweise hinreichend genau. Zum anderen läßt sich mit geringem Rechenaufwand jeweils an drei benachbarte Parameterwerte eindeutig ein Polynom zweiten Grades, das durch diese abgeglichenen Parameterwerte verläuft, anpassen. Außerdem ist die Anzahl der abzuspeichernden Funktionskoeffizienten gering. Für jeden abgeglichenen Parameterwert werden drei Koeffizienten abgespeichert, mit deren Hilfe anschließend beliebige Zwischenwerte zwischen den experimentell abgeglichenen Parameterwerten berechnet werden können.

Die vorliegende Erfindung ist nicht nur auf ein einzelnes Abbildungssystem anwendbar. Die Erfindung ist vielmehr auch auf mehrere miteinander gekoppelte Abbildungssysteme anwendbar, z.B. auf das kondensorseitige und abbildungsseitige Abbildungssystem in einem Elektronenmikroskop. Im sogenannten "Constant Brightness Mode" ist beispielsweise bei einer Änderung der Projektivvergrößerung eine daran automatisch angekoppelte Vergrößerungsänderung des Kondensorsystems möglich, so daß die Leuchtschirmhelligkeit konstant bleibt.

Nachfolgend werden Einzelheiten der Erfindung anhand des in den Figuren dargestellten Ausführungsbeispiels näher erläutert.

Im einzelnen zeigen:

Figur 1    eine perspektivische Darstellung eines Elektronenmikroskopes;

Figur 2    ein Blockdiagramm der elektronischen und elektronenoptischen Komponenten des Elektronenmikroskops aus Figur 1;

Figur 3    ein Flußdiagramm der Funktionsabläufe beim Abgleich des Elektronenmikroskops aus den Figuren 1 und 2;

Figur 4    ein Flußdiagramm der Funktionsabläufe beim Einschalten des Elektronenmikroskops aus den Figuren 1 und 2 nach erfolgtem experimentellem Abgleich und

Figur 5    ein Diagramm der Strom - Vergrößerungskennlinien eines erfindungsgemäßen elektronenoptischen Abbildungssystems.

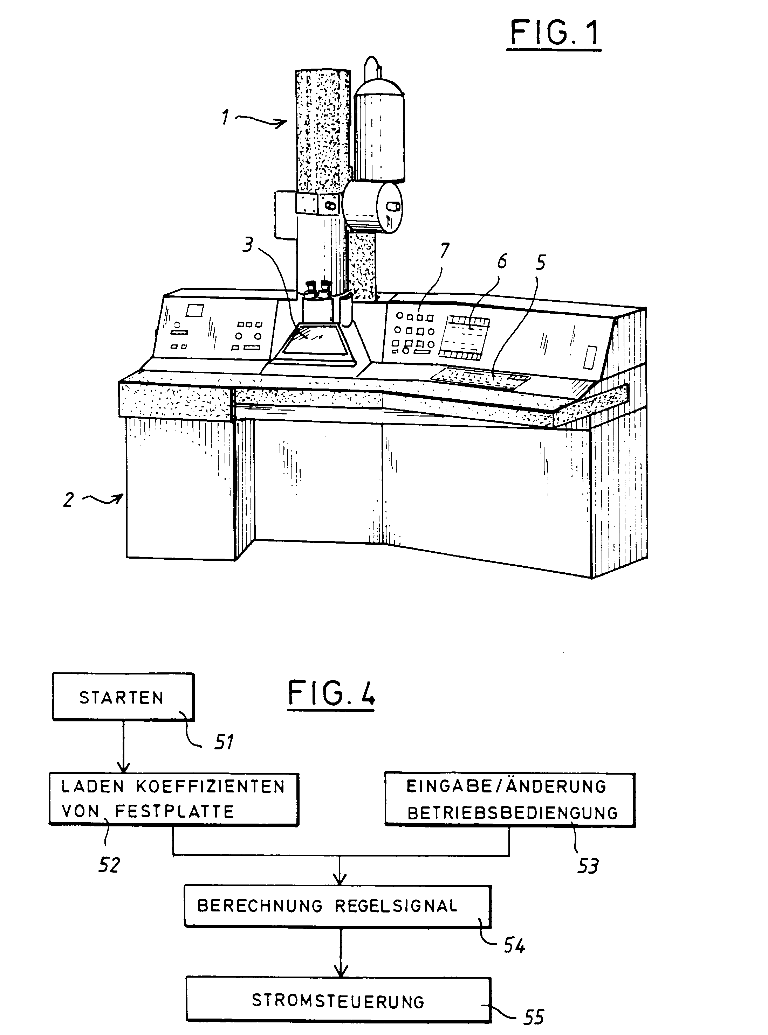

Das Elektronenmikroskop in der Figur 1 enthält eine elektronenoptische Säule (1) mit den nicht im einzelnen dargestellten elektronenoptischen Komponenten. Die elektronenoptische Säule (1) bildet mit einem Bedienpult (2) eine Einheit. Über ein Fenster (3) in der Projektionskammer des Elektronenmikroskops kann das Probenbild auf einem nicht dargestellten Fluoreszenzschirm beobachtet werden. Im Bedienpult (2) ist noch ein kommerzieller Rechner mit einem Festplattenspeicher integriert. Die zugehörige Tastatur ist mit (5) und der Monitor mit (6) bezeichnet. Darüber hinaus sind im Bedienpult die Strom- und Spannungsquellen für die elektronenoptischen Elemente der Säule (1) enthalten. Desweiteren ist am Bedienpult (2) ein Tastenfeld (7) in der Nähe der Projektionskammer angeordnet, so daß ein durch das Fenster (3) in die Projektionskammer einblickender Beobachter gleichzeitig über das Tastenfeld (7) die Betriebsbedingungen des Elektronenmikroskops verändern kann. Während bei Elektronenmikroskopen nach dem Stand der Technik über ein derartiges Tastenfeld (7) lediglich solche Betriebsbedingungen einstellbar sind, bei denen das Elektronenmikroskop zuvor experimentell abgeglichen wurde, erlaubt das Tastenfeld (7) des erfindungsgemäßen Elektronenmikroskopes auch die Eingabe von Betriebsbedingungen, die zwischen solchen experimentell abgeglichenen Betriebsbedingungen liegen.

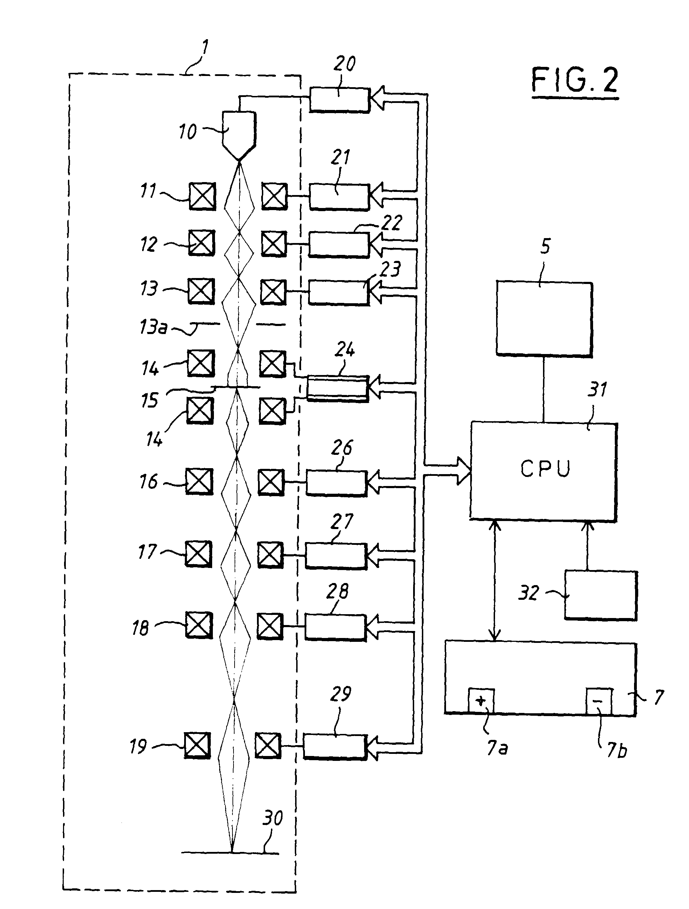

Wie in der Figur 2 näher dargestellt ist, enthält die Elektronensäule (1) eine Elektronenquelle (10) mit einer zugeordneten Strom- und Spannungsquelle (20) . Das in der Spaltmitte des Polschuhs einer Kondensor-Objektiv-Einfeldlinse (14) angeordnete Objekt (15) wird durch den aus der Elektronenquelle (10) austretenden Elektronenstrahl ausgeleuchtet. Zwischen der Elektronenquelle (10) und der Kondensor-Objektiv-Einfeldlinse (14) sind drei weitere magnetische Kondensorlinsen (11, 12, 13) angeordnet. Durch Variation der Erregungsströme der Kondensorlinsen (11, 12, 13) über deren Stromquellen (21; 22, 23) ist entweder im TEM-Betrieb die Apertur des Elektronenbündels oder im Scanning Betrieb die Größe der Elektronensonde auf dem Objekt (15) variierbar. Zwischen der dritten Kondensorlinse (13) und der Kondensor-Objektiv-Einfeldlinse (14) ist eine Kondensorblende (13a) angeordnet. Die Kondensorblende (13a) kann dabei als Mehrfachblende für die Einstellung unterschiedlicher Leuchtfelder im TEM-Betrieb oder für die Einstellung unterschiedlicher Sondenaperturen im Scanning-Betrieb ausgebildet sein. Die für die Blendenauswahl erforderlichen Ablenksysteme sind in der Figur 2 nicht dargestellt. Bezüglich der Einzelheiten der Leuchtfeldauswahl sei vielmehr auf die US-A 5 013 913 und bezüglich der Aperturauswahl auf die Anmeldung P42 43 489.0 der Anmelderin verwiesen.

Mit Hilfe der Kondensor-Objektiv-Einfeldlinse (14) und vier nachfolgenden Vergrößerungsstufen aus Magnetlinsen (16, 17, 18, 19) und zugehörigen Stromquellen (26, 27, 28, 29) wird das Objekt (15) vergrößert auf den Fluoreszenzschirm (30) abgebildet. Dieses vergrößerte Bild des Objektes (15) ist durch das Fenster (3) in der Projektionskammer beobachtbar.

Prinzipiell sind die Erregungen sämtlicher Magnetlinsen (11, 12, 13, 14, 16, 17, 18, 19) unabhängig voneinander einstellbar. Für die Einhaltung definierter Beleuchtungs- und Beobachtungsbedingungen sind jedoch die Erregungsparameter der Magnetlinsen miteinander gekoppelt. Damit die Einhaltung definierter Beleuchtungs- und Beobachtungsbedingungen stets gewährleistet ist, erfolgt die Regelung der Strom- und Spannungsquellen (20-29) über einen Rechner (31) mit daran angeschlossenem Festplattenspeicher (32). Die Eingabe und Änderung der Betriebsbedingungen erfolgt zum Teil über ein an den Rechner angeschlossenes Tastenfeld (7) und zum anderen Teil über die Rechnertastatur (5).

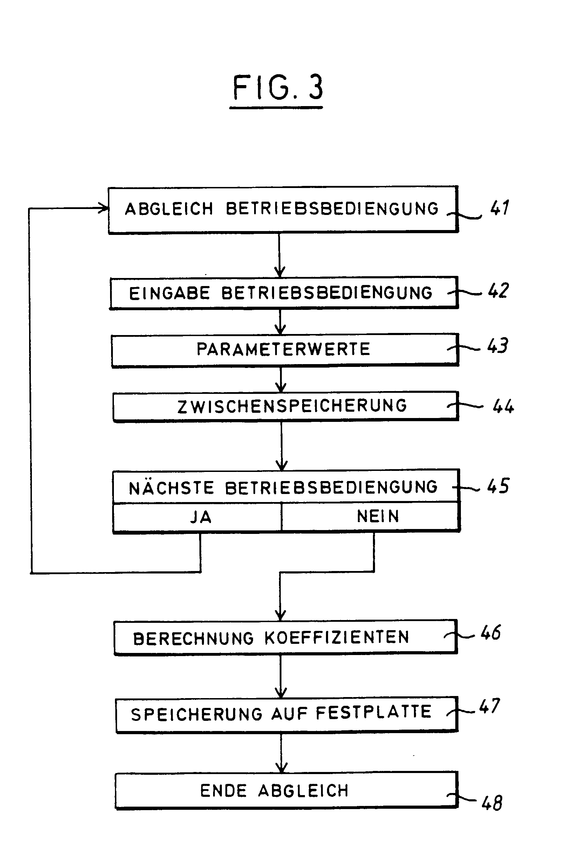

Bei der erstmaligen Inbetriebnahme erfolgt der experimentelle Abgleich des Elektronenmikroskops durch Werkspersonal. Dieser Abgleich erfolgt entsprechend des in der Figur 3 dargestellten Flußdiagrammes.

In einem ersten Schritt (41) werden zunächst in diskreten Stufen die zur abzugleichenden Betriebsbedingung zugehörigen Linsenerregungen über das Tastenfeld (7) manuell so eingestellt, daß der Elektronenstrahl innerhalb der Elektronensäule (1) den gewünschten Strahlverlauf erhält. Sobald der gewünschte Strahlverlauf eingestellt ist, werden in einem zweiten Schritt (42) den eingestellten Betriebszustand charakterisierende Parameter wie Vergrößerung, Elektronenenergie, Leuchtfelddurchmesser, Apertur, etc. über die Rechnertastatur (5) eingegeben. Nach Abschluß dieser Eingabe werden automatisch die an den Strom- und Spannungsquellen (20-29) eingestellten abgeglichenen Parameterwerte an den Rechner (31) ausgelesen und in einem nachfolgenden Schritt (44) unter Zuordnung zu den eingegebenen charakteristischen Werten auf dem Plattenspeicher (32) zwischengespeichert.

In einem darauffolgenden Schritt (45) wird abgefragt, ob eine weitere Betriebsbedingung experimentell abgeglichen werden soll. Im Falle, daß weitere Betriebsbedingungen experimentell abzugleichen sind, werden die Funktionsschritte (41, 42, 43, 44, 45) für jede abzugleichende Betriebsbedingung durchlaufen.

Nachdem das Elektronenmikroskop in einer ausreichenden Anzahl von Betriebsbedingungen experimentell abgeglichen wurde, wird im Funktionsschritt (45), also bei der Abfrage, ob der manuelle Abgleich einer weiteren Betriebsbedingung gewünscht ist, mit nein beantwortet. Der Rechner (31) berechnet dann in einem Schritt (46) zu jeder abgeglichenen Betriebsbedingung aus den zugehörigen zwischengespeicherten Parameterwerten und den entsprechenden zwischengespeicherten Parameterwerten der beiden nächst benachbarten Linsenstromstufen das durch diese drei abgeglichenen Parameterwerte hindurchgehende Polynom zweiten Grades. Ist $In(k)$ der Strom der n-ten Linse im Betriebszustand k und sind mit k-1 und k+1 die zu k benachbarten Betriebszustände bezeichnet, bei denen das Elektronenmikroskop experimentell abgeglichen ist, so wird $In(k)$ entsprechend Gleichung 1 dargestellt:

$$In(k) = a\,(k+b)^2 + c \qquad (1)$$

Aus entsprechender Anwendung der Gleichung 1 auf die zu den charakteristischen Parametern k+1 und k-1 zugehörigen Linsenströme $In(k+1)$ und $In(k-1)$ der n-ten Linse und ineinander einsetzen der so entstandenen drei Gleichungssysteme folgt, daß sich die Funktionskoeffizienten a, b, c entsprechend den Gleichungen 2, 3 und 4 berechnen lassen.

$$a = \frac{In(k\text{-}1) - In(k)}{1 - 2^*(k+b)} \qquad (2)$$

$$b = \frac{- 4k*\ln(k) + (2k-1)*\ln(k+1) + (2k+1)*\ln(k-1)}{2*(2*\ln(k) - (\ln(k-1) + \ln(k+1)))} \qquad (3)$$

$$c = \ln(k) - a*(k+b)^2 \qquad (4)$$

Die Berechnung der Funktionskoeffizienten a, b, c entsprechend den Gleichungen 2, 3 und 4 wird im Funktionsschritt (46) für jede Linse des Elektronenmikroskopes und für jeden Betriebszustand mit dem charakteristischen Parameter k, bei dem das Elektronenmikroskop experimentell abgeglichen wurde, durchgeführt. Ist das Elektronenmikroskop insgesamt unter K Bedingungen abgeglichen worden, so ergeben sich für die acht voneinander unabhängig einstellbaren Magnetlinsen des Elektronenmikroskops 8 x K Sätze von Funktionskoeffizienten a, b und c. Diese 8 x K Sätze von Funktionskoeffizienten werden in einem nachfolgenden Speicherschritt (47) auf der Festplatte (32) abgespeichert. Nach der Abspeicherung der Funktionskoeffizienten ist der experimentelle Abgleich des Elektronenmikroskops beendet und das Abgleichprogramm wird mit dem Schritt (48) verlassen.

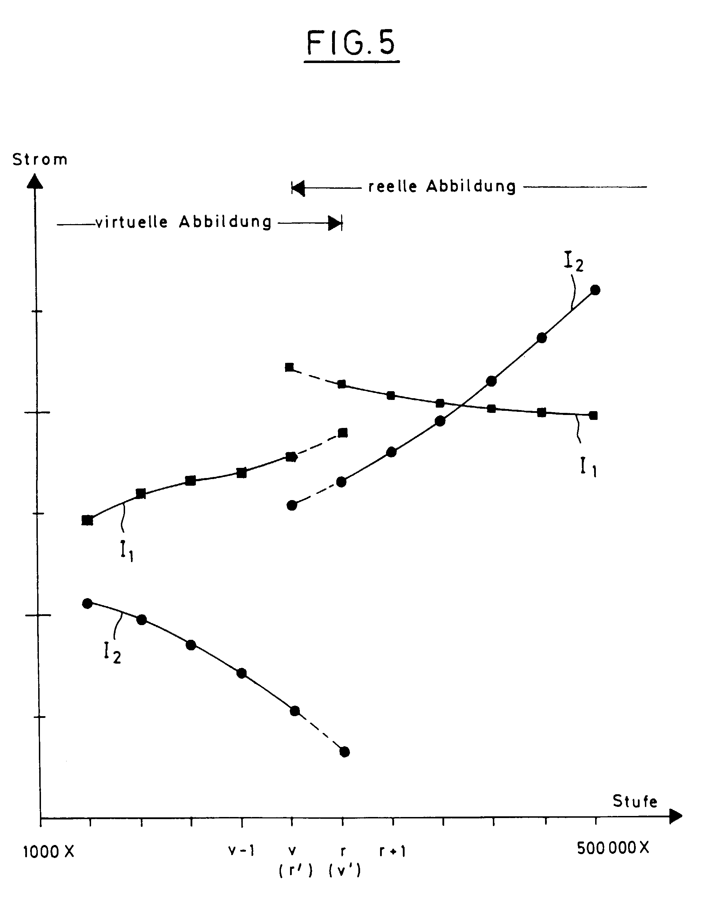

Bei einem späteren Einschalten des Elektronenmikroskopes (Funktionsschritt 51) werden in einem Initialisierungsschritt (52) (siehe Figur 4) die Funktionskoeffizienten vom Festplattenspeicher (32) in den Rechner (31) geladen. Die Eingabe oder Änderung der Betriebsbedingungen erfolgt in einem Schritt (53) über das Tastenfeld (7). Die Schrittweite für die fein abgestufte Änderung kann dabei über die Tastatur (5) eingegeben werden. Bei einer frei eingestellten Schrittweite ($\delta$) wird der Linsenstrom der n-ten Linse $\ln(k+m*\delta)$ entsprechend der Gleichung 5 berechnet:

$$\ln(k+m*\delta) = a*((k+m*\delta) + b)^2 + \ln(k) - a*(k+b)^2 \qquad (5)$$

Dabei ist (m) eine ganze positive oder negative Zahl und $\delta < 1$ ein ganzzahliger Bruchteil von 1. Diese Rechnung wird für alle acht Linsen des Elektronenmikroskops durchgeführt und anschließend werden die so berechneten Linsenströme in einem Schritt (55) an die Stromquellen (21, 22, 23, 24, 25, 26, 27, 28, 29) weiter gegeben. Die Erregung sämtlicher Linsen wird dabei gleichzeitig geändert. Bei der Berechnung anhand der Gleichung 5 wird für alle Linsenströme zwischen $\ln(k-1)$ und $\ln(k+1)$ als zentrale Stützstelle der Parameter k verwendet.

Ergeben sich über die Auf- und Abtaster (7a,7b) am Bedienpult (7) Linsenströme die kleiner als $\ln(k-1)$ oder größer als $\ln(k+1)$ sind, so werden in dem neu entstehenden Intervall die Linsenströme anhand einer zu Gleichung 5 entsprechenden Gleichung berechnet, in der jedoch $\ln(k)$ durch $\ln(k-1)$ oder $\ln(k+1)$ und für a, b und c die zu k-1 bzw. k+1 zugehörigen Funktionskoeffizienten verwendet werden. Dadurch ergeben sich überlappende Intervalle. Ein Springen der Stromwerte an Randpunkten ist dadurch vermieden. Die Schrittweite für ($\delta$) ist, da kein weiterer experimenteller Abgleich erforderlich ist, im Prinzip beliebig klein wählbar.

Zur Minimierung von außeraxialen Bildfehlern (Verzeichnung, radialer Farbfehler) werden Projektivsysteme bis zu etwa mittlerer Vergrößerung mit virtueller Zwischenabbildung betrieben und erst im höheren Vergrößerungsbereich erzeugen alle Linsen eine reelle Zwischenabbildung. Beim Übergang von virtueller zu reeller Abbildung entstehen Unstetigkeiten in den Linsenstromkurven. In der Figur 5 sind die Linsenströme I1 und I2 zweier Linsen über einen Vergrößerungsbereich von 1000 x bis 500.000 x aufgetragen. Der Übergang von der virtuellen Zwischenabbildung zur reellen Zwischenabbildung findet bei etwa 25.000-facher Vergrößerung statt. Mit v ist die größte Vergrößerungsstufe bezeichnet, bei der das Elektronenmikroskop üblicherweise noch mit virtueller Zwischenabbildung betrieben wird. Mit r = v + 1 ist entsprechend die kleinste Vergrößerungsstufe bezeichnet, bei der eine reelle Zwischenabbildung üblich ist. Um auch zwischen v und r beliebige Vergrößerungswerte einzustellen, wird das Elektronenmikroskop zusätzlich bei einer virtuellen Zwischenstufe v' und einer reellen Zwischenstufe r' abgeglichen, wobei der Vergrößerungswert der virtuellen Zwischenstufe v' gleich dem Wert r der ersten reellen Stufe und der Vergrößerungswert der reellen Zwischenstufe r' gleich dem Wert der letzten virtuellen Stufe v entspricht. Die Zwischenstufen dienen nicht als zentrale Stützpunkte sondern nur zur Berechnung von Funktionskoeffizienten in benachbarten Stützpunkten. Die Auswahl, welche Zwischenstufe r' oder v' bei Vergrößerungen zwischen v und r zugrunde gelegt wird, hängt dabei davon ab, von welcher Seite aus die Vergrößerung in den Bereich zwischen v und r hinein eingestellt wird. Dadurch ist auch in diesem Zwischenbereich ein unstetiges Ändern der Linsenerregungen bei der Feineinstellung vermieden.

Für die Berechnung der Funktionskoeffizienten und für die Berechnung der Linsenströme aus diesen Funktionskoeffizienten ist keine Kenntnis der Brennweiten bzw. der Bahngleichungen des Elektronenstrahls erforderlich. Die Erfindung ist daher auch bei rein empirisch gefundenen Parameterwerten für die Linsenströme einsetzbar. Die Berechnung der Zwischenwerte entsprechend der Erfindung minimiert Hystereseeffekte der Linsen, die speziell bei großen Brennweitenvariationen auftreten.

Die Erfindung ist nicht nur bei einem einzelnen Abbildungssystem, sondern auch bei der Kombination mehrerer Abbildungssysteme anwendbar. Eine derartige Kombination zweier Abbildungssysteme stellen beispielsweise in der Figur 2 die beleuchtungsseitigen Kondensorlinsen (11, 12, 13, 14) einerseits und die abbildungsseitigen Linsen (14, 16, 17, 18, 19) dar. Wird beispielsweise über das Tastenfeld (7) der sogenannte "Constant Brightness Mode" eingestellt und die abbildungsseitige Vergrößerung mit Hilfe der Auf- und Abtaster (7a, 7b) variiert, so werden automatisch vom Rechner (31) anhand der geladenen Funktionskoeffizienten für die Linsen (11, 12 und 13) Linsenstromwerte derart berechnet, daß die Bildhelligkeit auf dem Fluoreszenzschirm (30) konstant ist.

Zur vereinfachten Darstellung wurde bei den Gleichungen 1-5 angenommen, daß die abgeglichenen Betriebzustände äquidistant seien und daher $m*\delta$ stets zwischen -1 und 1 liegt. Dieses ist jedoch für die Anwendung der Erfindung nicht erforderlich. Liegt beispielsweise zwischen den abgeglichen Zuständen k-1 und k ein Abstand $x_1$ und zwischen den abgeglichenen Zustände k und k+1 ein Abstand $x_2$ so läßt sich der Strom der n-ten Linse in allen Zuständen zwischen k-1 und k+1 durch folgende beiden, zur Gleichung 1 analogen Gleichungen 1a und 1b darstellen:

$$\ln(k+x_2) = a\,(k + x_2 + b)^2 + c \qquad\qquad (1a)$$

$$\ln(k-x_1) = a\,(k - x_1 + b)^2 + c \qquad\qquad (1b)$$

Zusammen mit der Gleichung 1 für ln(k) ergibt sich wiederum ein System aus drei Gleichungen für die drei Unbekannten a, b und c und daraus eine zu Gleichung 5 analoge Gleichung zur Berechnung der Zwischenzustände.

Natürlich ist die Erfindung nicht nur zur Einstellung von zwischen abgeglichenen Vergrößerungen liegende Vergrößerungen anwendbar sonder auch für andere variierbare Parameter wie Elektronenstromdichte, Bilddrehung etc.

**Patentansprüche**

1. Elektronenoptisches Abbildungssystem, das mehrere regelbare, einen Elektronenstrahl beeinflussende Elemente (11, 12, 13, 14, 16, 17, 18, 19) mit zugehörigen Strom- oder Spannungsquellen (21, 22, 23, 24, 26, 27, 28), einen Speicher (32) und einen Rechner (31) umfaßt, wobei in dem Speicher Werte abgelegt sind, die aus experimentel abgeglichenen Parameterwerten des Abbildungssystems bei einer diskreten Folge unterschiedlicher, abgeglichener Betriebsbedingungen ermittelt sind, wobei eine Schrittweite $\delta$ für eine Änderung der Betriebsbedingungen von der Lage der abgeglichenen Betriebsbedingungen unabhängig vorwählbar ist und wobei bei Betätigung eines Bedienelementes (7a, 7b) ausgehend von der aktuel eingestellten Betriebsbedingung eine Änderung der Betriebsbdingung entsprechend der vorgewählten Schrittweite $\delta$ in eine neue aktuelle Betriebsbedingung erfolgt, wozu die zu der aktuel eingestellten Betriebsbedingung zugehörigen Regelsignale der Strom- oder Spannungsquellen (21, 22, 23, 24, 26, 27, 28, 29) aus den abgespeicherten Werten im Rechner (31) berechnet werden.

2. Elektronenoptisches Abbildungssystem nach Anspruch 1, wobei die abgespeicherten Werte Koeffizienten von Näherungsfunktionen sind und die Regelsignale anhand dieser Koeffizienten und den zugehörigen Näherungsfunktionen berechnet sind.

3. Elektronenoptisches Abbildungssystem nach Anspruch 2, wobei die Näherungsfunktionen jeweils innerhalb eines Intervalles stetig sind und die zu jeweils zwei Näherungsfunktionen zugehörigen Stetigkeitsintervalle jeweils überlappend sind.

4. Elektronenoptisches Abbildungssystem nach Anspruch 3 oder 4, wobei die Näherungsfunktionen Polynome zweiten Grades sind.

5. Elektronenoptisches Abbildungssystem nach einem der Ansprüche 1 bis 4, wobei die den Elektronenstrahl beeinflussenden Elemente (11, 12, 13, 14, 16, 17, 18, 19) Magnetlinsen sind.

6. Elektronenmikroskop mit einem elektronenoptischen Abbildungssystem nach einem der Ansprüche 1-5.

7. Elektronenmikroskop nach Anspruch 6, wobei die Betriebsbedingungen am Bedienpult (2) des Elektronenmikroskopes einstellbar sind.

8. Elektronenmikroskop nach Anspruch 7, wobei die Betriebsbedingungen mittels eines Tastenfeldes (7) am Bedienpult (2) des Elektronenmikroskopes variierbar sind.

9. Elektronenmikroskop nach einem der Ansprüche 6-8, mit mindestens einem ersten Abbildungssystem (11, 12, 13, 14) zwischen der Elektronenquelle (10) und der Objektebene (15) und einem zweiten Abbildungssystem (14, 16, 17, 18, 19) zwischen der Objektebene (15) und einer Projektionsebene (30) und wobei das erste und zweite Abbildungssystem miteinander gekoppelt sind, so daß bei einer Änderung der Betriebsbedingungen des zweiten Abbildungssystems (14, 16, 17, 18, 19) die Betriebsbedingungen des ersten Abbildungssystems (11, 12, 13, 14) derart geändert werden, daß die Bildhelligkeit in der Projektionsebene (30) konstant ist.

## Claims

1. Electron-optical imaging system comprising a plurality controllable elements (11, 12, 13, 14, 16, 17, 18, 19) with corresponding current or voltage sources (21, 22, 23, 24, 26, 27, 28), a memory (32) and a computer (31), whereby values are stored in the memory which are determined from experimentally adjusted parameter values of the imaging system in a discret series of different adjusted operating conditions, whereby a step width 6 for changing the operating conditions is selectable independently of the position of the adjusted operating conditions and whereby, when operating a control element (7a, 7b), starting from the actual adjusted operating condition a change of the operating condition according to the selected step width 6 into a new actual operating condition is performed, for which the control signals of the current and voltage sources (21, 22, 23, 24, 26, 27, 28, 29) corresponding to the actual adjusted operating condition are calculated from the stored values by the computer (31).

2. Electron-optical imaging system of claim 1, whereby the stored values are coefficients of approximation functions and whereby the control signals are calculated by the aid of these coefficients and the corresponding approximation functions.

3. Electron-optical imaging system of claim 2, wherein the approximation functions each are steady functions in an interval and whereby the intervals in which each two approximation functions are steady are mutually overlapping.

4. Electron-optical imaging system of claim 2 or 3, whereby the approximation functions are polynomes of second degree.

5. Electron-optical imaging system of one of the claims 1 to 4, whereby the elements (11, 12, 13, 14, 16, 17, 18, 19) acting on the electron beam are magnetic lenses.

6. Electron-microscope comprising an electron-optical imaging system of one of the claims 1 to 5.

7. Electron-microscope of claim 6, whereby the operating conditions are changeable at the operating console (2) of the electron microscope.

8. Electron-microscope of claim 7, whereby the operating conditions are changeable by the aid of a touch panel (7) at the operating console (2) of the electron microscope.

9. Electron-microscope of one of the claims 6 to 8, with at least one imaging system (11, 12, 13, 14) between an electron source (10) and a sample plane (15) and a second imaging system (14, 16, 17, 18, 19) between the sample plane (15) and a projection plane (30) and wherein the first and second imaging systems are coupled one to the other so that with a change of the operating conditions of the second imaging system (14, 16, 17, 18, 19) also the operating conditions of the first imaging system (11, 12, 13, 14) are changed in a manner that the brightness of the image in the projection plane (30) is constant.

## Revendications

1. Système de reproduction d'optique électronique comprenant plusieurs éléments réglables agissant sur le faisceau électronique (11, 12, 13, 14, 16, 17, 18, 19) et les sources de courant ou de tension qui leur sont affectées (21, 22, 23, 24, 26, 27, 28, 29), ainsi qu'une mémoire (32) et un ordinateur (31), où la mémoire (32) contient des valeurs déterminées à partir de paramètres ajustés par voie expérimentale du système de reproduction pour une suite de régimes de fonctionnement discrets ajustés, où un pas de progression 6 permettant de s'écarter des régimes de fonctionnement ajustés peut être présélectionné indépendamment des valeurs desdits régimes de fonctionnement ajustés et où l'actionnement d'un élément de commande (7a, 7b) provoque une modification des conditions de fonctionnement à partir du régime de fonctionnement réglé en fonction du pas de progression présélectionné 6 pour appliquer un nouveau régime de fonctionnement, les signaux de réglage des sources de courant ou de tension (21, 22, 23, 24, 26, 27, 28, 29) correspondant au régime de fonctionnement réglé étant calculés par l'ordinateur à partir des valeurs mises en mémoire.

2. Système de reproduction d'optique électronique selon la revendication 1, où les valeurs mises en mémoire sont des coefficients de fonctions d'approximation et où les signaux de réglage sont calculés au moyen de ces coefficients et des fonctions d'approximation correspondantes.

3. Système de reproduction d'optique électronique selon la revendication 2, où les fonctions d'approximation sont continues respectivement à l'intérieur d'un intervalle donné et où les intervalles de continuité associés respectivement à deux fonctions d'approximation se chevauchent respectivement.

4. Système de reproduction d'optique électronique selon la revendication 2 ou 3, où les fonctions d'approximation sont des polynômes de deuxième ordre.

5. Système de reproduction d'optique électronique selon l'une des revendications 1 à 4, où les éléments agissant sur le faisceau électronique (11,12, 13, 14, 16, 17, 18, 19) sont des lentilles magnétiques.

6. Microscope électronique avec un système de reproduction d'optique électronique selon l'une des revendications 1 à 5.

7. Microscope électronique selon la revendication 6, où les régimes de fonctionnement sont réglables au niveau du pupitre de commande (2) du microscope électronique.

8. Microscope électronique selon la revendication 7, où les régimes de fonctionnement peuvent être changés à partir d'un clavier de touches (7) aménagé sur le pupitre de commande (2) du microscope électronique.

9. Microscope électronique selon l'une des revendications 6 à 8 avec au moins un premier système de reproduction (11, 12, 13, 14) compris entre la source d'électrons (10) et le plan d'objet (15) et un second système de reproduction (14, 16, 17, 18, 19) compris entre le plan d'objet (15) et un plan de projection (30), où le premier et le second système de reproduction sont accouplés, de telle sorte que lors d'un changement du régime du second système de reproduction (14, 16, 17, 18, 19), le régime de fonctionnement du premier système de reproduction (11, 12, 13, 14) est modifié de façon à ce que l'intensité lumineuse de l'image formée dans le plan de projection (30) reste constante.

<u>FIG. 1</u>

<u>FIG. 4</u>

```
STARTEN
                    51
LADEN KOEFFIZIENTEN        EINGABE/ÄNDERUNG
VON FESTPLATTE             BETRIEBSBEDIENGUNG
52                                        53
        BERECHNUNG REGELSIGNAL
                                54
        STROMSTEUERUNG
                                55
```

FIG. 2

# FIG. 3

| ABGLEICH BETRIEBSBEDIENUNG | 41 |

| EINGABE BETRIEBSBEDIENUNG | 42 |

| PARAMETERWERTE | 43 |

| ZWISCHENSPEICHERUNG | 44 |

| NÄCHSTE BETRIEBSBEDIENUNG | 45 |
|---|---|
| JA | NEIN |

| BERECHNUNG KOEFFIZIENTEN | 46 |

| SPEICHERUNG AUF FESTPLATTE | 47 |

| ENDE ABGLEICH | 48 |

# FIG.5